# EUROPEAN PATENT APPLICATION

(11) **EP 2 479 802 A1**
(43) Date of publication of application: **25.07.2012**
(21) Application number: 10817216.4
(22) Date of filing: 15.09.2010
(51) Int. Cl.: H01L 31/042

(54) **SOLAR CELL MODULE AND METHOD FOR MANUFACTURING SAME**

(30) Priority: 15.09.2009 JP 2009213387
(71) Applicant: Sharp Kabushiki Kaisha, Osaka-shi, Osaka 545-8522 (JP)
(72) Inventor: TOYA, Masao, Osaka 545-8522 (JP)
(74) Representative: Hoffmann, Jörg Peter
(86) International application number: PCT/JP2010/065972
(87) International publication number: WO 2011/034103

(57) **Abstract**

A solar cell module (101) includes a wiring sheet (10) formed such that n-type and p-type wirings (12, 13) are alternately arranged in a striped pattern on a surface of a sheet-like insulating substrate (11), and a back contact solar cell (20) formed such that n-type and p-type electrodes (24, 25) electrically connected to impurity diffusion regions (22, 23) are alternately arranged in a striped pattern on one surface of a semiconductor substrate (21). The electrodes (24, 25) and the wirings (12, 13) are connected through conductors (29c) so as to satisfy a one-to-one relationship. The periphery of the conductor (29c) is covered with an insulating resin (29i). An insulator (28) having a composition different from the insulating resin (29i) is mounted between the adjacent electrodes (24, 25) on the back contact solar cell (20).

## Description

### TECHNICAL FIELD

The present invention relates to a solar cell module and a method of manufacturing the same.

### BACKGROUND ART

In recent years, development of clean energy has been desired in view of global environment problems such as depletion of energy resources and increasing CO₂ in the air. In particular, solar photovoltaic power generation using solar cell modules has been developed and put into practical use as a new energy source and has been on a growth path.

The structure of such a solar cell module includes a solar cell. Double-sided contact solar cells have been the mainstream of solar cells. The "double-sided contact solar cell" is the one in which, for example, a light-receiving surface is formed from a monocrystalline or polycrystalline silicon substrate, a pn junction is formed by diffusing an impurity of a conductivity type opposite to the silicon substrate into the light-receiving surface, and electrodes are formed on the light-receiving surface of the silicon substrate and on the opposite, back surface. In recent years, back contact solar cells have also been developed. The "back contact solar cell" is the one in which a p-type electrode and an n-type electrode are both formed on the back surface of a silicon substrate.

In order to improve power generation efficiency of back contact solar cells, the density of the p and n diffusion layers arranged on the same plane has to be increased. With the density being increased, the distance between electrodes or between wiring (hereinafter collectively referred to as "terminal-to-terminal distance") tends to be reduced. The bonding between such a back contact solar cell and a wiring sheet may be made by conventional methods using a conductive adhesive or solder paste. However, when the terminal-to-terminal distance is short, the method using a conductive adhesive has a problem of causing a short circuit between electrodes or between wiring adjacent to each other. In the bonding using solder paste which is usually used in the bonding of electrodes in electronic components, solder heated to flow causes a short circuit between electrodes or between wiring, and the terminal-to-terminal distance is too short to fill the underfill completely.

In order to address these problems, Japanese Patent Laying-Open No. 9-246317 (PTL 1) entitled "Method of Fixing Chip and Substrate" discloses a technique for preventing a short circuit caused by solder flowing during heating by forming a wall portion between electrodes in advance using a photo-curable resin.

### CITATION LIST

### PATENT LITERATURE

PTL 1: Japanese Patent Laying-Open No. 9-246317

### SUMMARY OF INVENTION

### TECHNICAL PROBLEM

A solar cell module can be fabricated by employing the fixing method described in PTL 1, for example, as follows.

First, an insulator such as a UV-curable resin is applied on one surface of a solar cell, and a pattern mask is laid on the surface and irradiated with light from above. The pattern mask is thereafter removed, and the uncured UV-curable resin is washed away. A wall portion is thus formed from the cured UV-curable resin. The surface of the solar cell having the wall portions is coated with solder paste and is grazed by a squeegee over the wall portion. As a result of the grazing, the solder paste remains in each region isolated by the wall portion. The solar cell processed in this manner and a wiring sheet are aligned with each other to be laminated. By doing so, the solder paste electrically connects the electrodes on the solar cell with the wiring on the wiring sheet.

In the solar cell module bonded by the fixing method described in PTL 1, the wall portion formed from the UV-curable resin is arranged between electrodes. However, the upper surface of the wall portion is still not adhered to the wiring sheet even in the state in which the connection between the solar cell and the wiring sheet is completed. Therefore, the connection strength between the solar cell and the wiring sheet cannot be high enough.

Furthermore, flux added in the solder paste volatilizes, and the residual solder paste forms solder bumps. Thus, the apparent volume of solder deceases after the connection, when compared with before the connection. As a result, even in the state in which continuity between the electrode of the solar cell and the wiring on the wiring sheet is established, a gap equivalent to a volume reduction is produced in the periphery of the solder bump. There is no choice but to leave the gap since it is difficult to additionally fill the underfill after the connection process is completed, as previously mentioned. As a result, the reliability is reduced.

In addition, when using this fixing method, although the squeegee grazes the -solder paste, the solder paste is inevitably left on the upper surface of the wall portion, which causes a short circuit between electrodes adjacent to each other.

The present invention therefore aims to prevent a short circuit between electrodes adjacent to each other and to provide a highly reliable solar cell module and a method of manufacturing the same.

### SOLUTION TO PROBLEM

In order to solve the problems above, a solar cell module based on the invention includes: a wiring sheet formed such that n-type wiring and p-type wiring are alternately arranged in a striped pattern on a surface of a sheet-like insulating substrate; and a back contact solar cell formed such that an n-type impurity diffusion region and a p-type impurity diffusion region are alternately arranged in a striped pattern in the inside of one surface of a semiconductor substrate and such that an n-type electrode and a p-type electrode electrically connected to the n-type impurity diffusion region and the p-type impurity diffusion region, respectively, are alternately arranged in a striped pattern on the one surface. The n-type electrode and the p-type electrode and the n-type wiring and the p-type wiring are connected through conductors so as to satisfy a one-to-one relationship. The periphery of the conductor is covered with an insulating resin. An insulator having a composition different from the insulating resin is mounted between the n-type electrode and the p-type electrode adjacent to each other on the back contact solar cell.

### ADVANTAGEOUS EFFECTS OF INVENTION

According to the present invention, the periphery of the conductor electrically connecting between the electrode of the back contact solar cell and the wiring on the wiring sheet is covered with an insulating resin, thereby preventing a short circuit between electrodes or between wiring adjacent to each other. In addition to the insulating resin, an insulator is further provided between electrodes, thereby preventing a short circuit between electrodes or between wiring adjacent to each other, more reliably. Therefore, the present invention provides a highly reliable solar cell module.

### BRIEF DESCRIPTION OF DRAWINGS

Fig. 1 is a cross-sectional view of a solar cell module in a first embodiment of the present invention.
Fig. 2 is a cross-sectional view showing a wiring sheet alone included in the solar cell module in the first embodiment of the present invention.
Fig. 3 is a plan view showing the wiring sheet alone included in the solar cell module in the first embodiment of the present invention.
Fig. 4 is a cross-sectional view showing a back contact solar cell alone included in the solar cell module in the first embodiment of the present invention.
Fig. 5 is a plan view showing the back contact solar cell alone included in the solar cell module in the first embodiment of the present invention.
Fig. 6 is a flowchart of a method of manufacturing a solar cell module in a second embodiment of the present invention.
Fig. 7 is a cross-sectional view schematically showing the back contact solar cell used in the method of manufacturing a solar cell module in the second embodiment of the present invention.
Fig. 8 is a first illustration of the method of manufacturing a solar cell module in the second embodiment of the present invention.
Fig. 9 is a second illustration of the method of manufacturing a solar cell module in the second embodiment of the present invention.
Fig. 10 is a third illustration of the method of manufacturing a solar cell module in the second embodiment of the present invention.
Fig. 11 is a fourth illustration of the method of manufacturing a solar cell module in the second embodiment of the present invention.
Fig. 12 is a fifth illustration of the method of manufacturing a solar cell module in the second embodiment of the present invention.
Fig. 13 is a sixth illustration of the method of manufacturing a solar cell module in the second embodiment of the present invention.
Fig. 14 is a seventh illustration of the method of manufacturing a solar cell module in the second embodiment of the present invention.
Fig. 15 is an eighth illustration of the method of manufacturing a solar cell module in the second embodiment of the present invention.
Fig. 16 is a ninth illustration of the method of manufacturing a solar cell module in the second embodiment of the present invention.
Fig. 17 is a tenth illustration of the method of manufacturing a solar cell module in the second embodiment of the present invention.
Fig. 18 is a cross-sectional view of the sealed solar cell module obtained by the method of manufacturing a solar cell module in the second embodiment of the present invention.

### DESCRIPTION OF EMBODIMENTS

Conventionally, techniques such as bonding using a conductive adhesive and bonding bus bar electrodes with solder have been adopted in the bonding between electrodes of a cell such as a solar cell. These techniques are effective in the bonding of the conventional cell having electrodes both on the front surface and the back surface. However, a short circuit between electrodes easily occurs in a cell having electrodes only on one surface, as in a back contact solar cell. Moreover, an underfill has to be injected after a cell and a wiring sheet are bonded together. This injection is extremely difficult.

When a back contact solar cell and a wiring sheet are to be bonded together, with the bonding using usual solder paste, the solder paste forms a solder bump, resulting in that the solder bump electrically connects an electrode on the back contact solar cell with wiring on the wiring sheet. In this case, a space is created on the periphery of the solder bump since the solder bump is individually formed corresponding to the location of each electrode. The present inventors then tried creating a bonding agent capable of bonding between a back contact solar cell and a wiring sheet without using solder paste. As a result, the present inventors have found a bonding method using solder resin paste obtained by adding solder fine powder to a thermosetting resin. In particular, the present inventors have realized such solder resin paste in that a low viscosity is kept until solder reaches a melting point and melts, the resin sets after the solder fine powder melts and coagulates, and the resin serves as an underfill agent after the resin sets completely. This solder resin paste is supplied on the electrodes and is pressed and heated in a vacuum chamber, whereby electrical continuity is kept between the electrodes of the back contact solar cell and the wiring on the wiring sheet by the molten solder produced from the solder resin paste. The molten solder coagulates to form a solder bump. The periphery of the solder bump is covered with the thermosetting resin included in the solder resin paste, so that the periphery of the solder bump is protected by the thermosetting resin. The reliability is thus ensured.

If such solder resin paste is supplied only on each electrode, the thermosetting resin covers each solder bump on the periphery of the solder bump. Bonding is thus achieved without any problem in terms of reliability. However, there still exists a gap between electrodes adjacent to each other, and it is difficult to fill the gap with resin.

In order to avoid this problem, the solder resin paste may be supplied on the entire surface of the back contact solar cell for the purpose of filling in all the regions between electrodes adjacent to each other (hereinafter referred to as "inter-electrode regions"). However, when solder resin paste having a reduced content of solder fine powder is used, a silver layer formed as an electrode on the back contact solar cell is not covered with solder, leading to migration. Conversely, when solder resin paste having an increased content of solder fine powder is used, a number of short circuits are caused between electrodes or between wiring adjacent to each other due to the solder component included in the solder resin paste supplied to the inter-electrode regions.

The shortfall of resin may be supplied by a dispenser or the like only to the inter-electrode region after the solder resin paste is supplied. In this case, however, solder particles flow out of the solder resin paste supplied on the electrode, into the resin supplied to the inter-electrode region. As a result of this phenomenon, a short circuit occurs between electrodes or between wiring after the bonding between the back contact solar cell and the wiring sheet is completed.

In the present invention, an insulator is supplied in advance in the inter-electrode region of the back-type contact solar cell. The supply of the insulator in this manner can make up the shortfall of resin in the case where the solder resin paste is used as a bonding agent. Furthermore, the insulator is cured in advance, so that the mutual interference between the insulator and the solder resin paste supplied in the subsequent step, that is, an outflow of solder particles, can be prevented. This is the same with the case where any other kind of metal fine powder is included in place of solder particles in the resin paste.

In the present invention, an insulator is supplied and cured in advance in each inter-electrode region on the back contact solar cell. The cured insulator forms a protrusion portion. Thereafter, the resin with addition of solder fine powder is supplied as a connecting agent on the electrodes of the back contact solar cell, and the back contact solar cell and the wiring sheet are aligned with each other and thereafter subjected to a lamination process.

When the solder resin paste and the protrusion portions formed by hardening the insulator are used at the same time in this way, even if a large amount of metal fine powder such as solder particles coagulates in the joining process to produce such a massive molten metal that extends over electrodes adjacent to each other, the protrusion portion formed from the insulator is pressed from above in the lamination process, so that the massive molten metal is divided apart at the protrusion portion as a boundary. In addition, the protrusion portion, which is formed from the insulator, can prevent a short circuit.

The structure thus obtained is such that all the spaces between the back contact solar cell and the wiring sheet are filled with resin without creating a short circuit between electrodes or between wiring adjacent to each other. Therefore, a highly reliable solar cell module can be obtained. In this case, the space between the back contact solar cell and the wiring sheet has already been filled with resin, thereby eliminating the need for the underfill injection step after the connection.

### (First Embodiment)

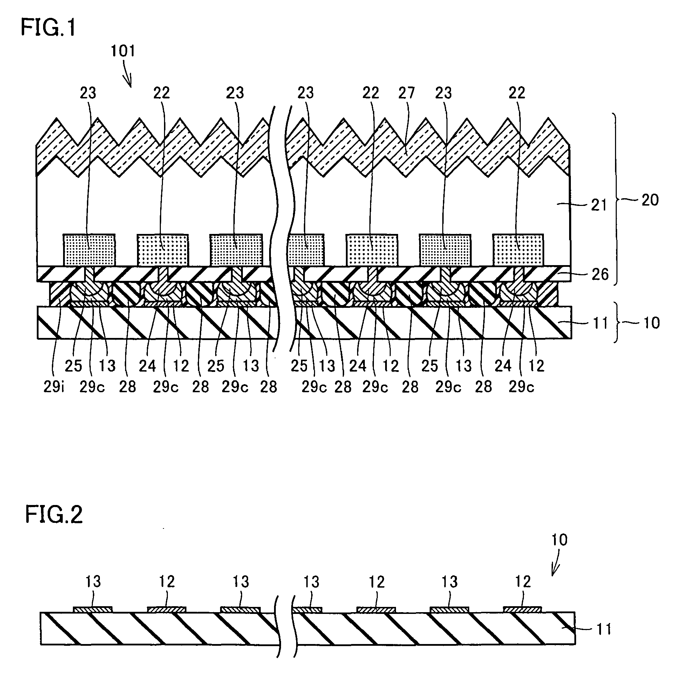

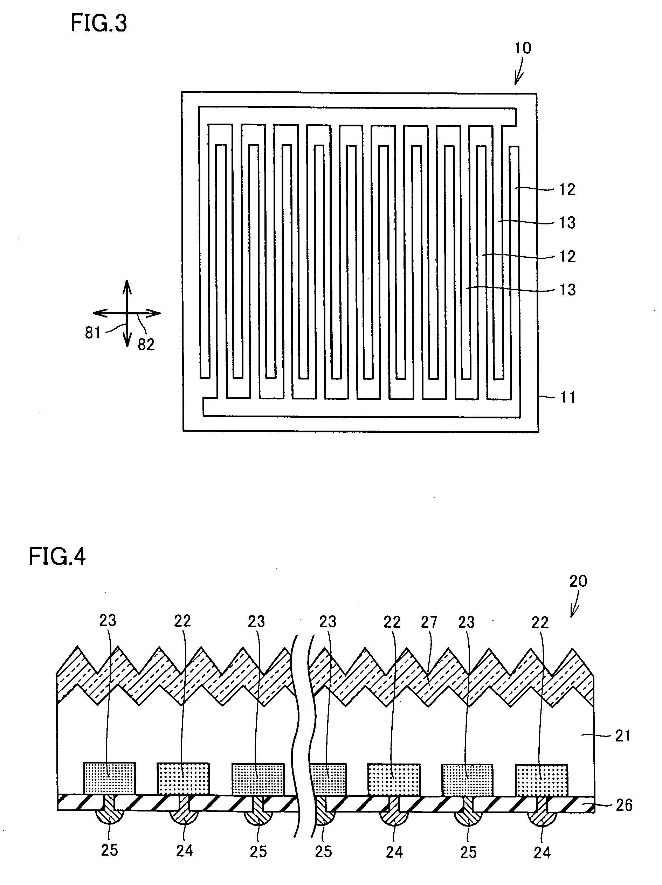

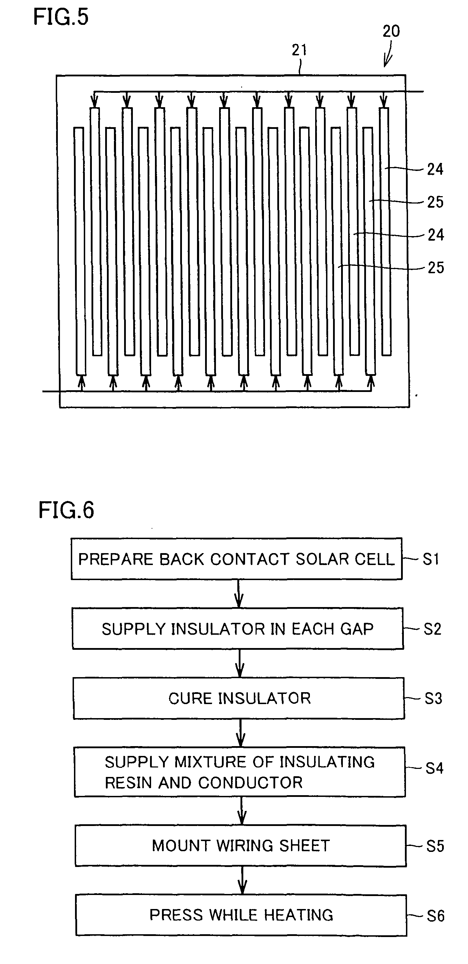

Referring to Fig. 1 to Fig. 5, a solar cell module in a first embodiment of the present invention will be described. A cross-sectional view of the solar cell module in the present embodiment is shown in Fig. 1. As shown in Fig. 1, a solar cell module 101 is a laminated product of a wiring sheet 10 and a back contact solar cell 20. Fig. 2 and Fig. 3 show wiring sheet 10 alone. Fig. 4 and Fig. 5 show back contact solar cell 20 alone.

As shown in Fig. 1, solar cell module 101 includes wiring sheet 10 and back contact solar cell 20. Wiring sheet 10 is formed such that n-type wiring 12 and p-type wiring 13 are alternately arranged in a striped pattern on a surface of a sheet-like insulating substrate 11. Back contact solar cell 20 is formed such that an n-type impurity diffusion region 22 and a p-type impurity diffusion region 23 are alternately arranged in a striped pattern in the inside of one surface of a semiconductor substrate 21 and such that an n-type electrode24 and a p-type electrode 25 electrically connected to n-type impurity diffusion region 22 and p-type impurity diffusion region 23, respectively, are alternately arranged in a striped pattern on the one surface. N-type electrode 24 and p-type electrode 25 and n-type wiring 12 and p-type wiring 13 are connected through conductors 29c so as to satisfy a one-to-one relationship. The periphery of conductor 29c is covered with an insulating resin 29i. An insulator 28 having a composition different from insulating resin 29i is mounted between n-type electrode 24 and p-type electrode 25 adjacent to each other on back contact solar cell 20.

In solar cell module 101 in the present embodiment, the periphery of conductor 29c electrically connecting between the electrode of back contact solar cell 20 and the wiring on wiring sheet 10 is covered with insulating resin 29i. Therefore, this structure can prevent a short circuit between electrodes or between wiring adjacent to each other. In addition to insulating resin 29i, insulator 28 is further mounted between electrodes, thereby preventing a short circuit between electrodes or between wiring adjacent to each other, more reliably. Therefore, the present embodiment can provide a highly reliable solar cell module.

In solar cell module 101 in the present embodiment, insulator 28 corresponds to the "protrusion portion" described above.

Insulator 28 supplied to form the protrusion portion may be any insulator as long as it is solidified during lamination in the subsequent step. Preferably, insulator 28 may be a thermosetting resin including one or more kinds selected from phenol resin, epoxy resin, melamine resin, urea resin, alkyd resin, and unsaturated polyester resin. Preferably, the viscosity is a viscosity in such a degree that does not cause dripping under its own weight after supply. Specifically, a viscosity of 200 Pa·s or more is preferred. In the present embodiment, the resin component included in the insulator is not limited only to the examples of resins illustrated here. It may be a photo-curable resin that is cured by ultraviolet rays.

In the present embodiment, preferably, insulator 28 is a thermosetting resin or a photo-curable resin. This is because the resin of these kinds can be easily cured after being arranged at the desired position.

A method for arranging insulator 28 on the surface of back contact solar cell 20 may be a printing method but not limited to a printing method, and may be inkjet, dispense, slit coat, and other methods. The height of insulator 28 immediately after being supplied is preferably higher than n-type electrode 24 and p-type electrode 25 formed on the same surface of back contact solar cell 20.

If bonding with wiring sheet 10 is performed while insulator 28 remains in contact with n-type electrode 24 or p-type electrode 25, the electrode material would not be covered with solder. Supposing that the electrode material is silver, migration is likely to be caused. Therefore, the supply width of insulator 28 is preferably a width in such a degree that does not come into contact with n-type electrode 24 and p-type electrode 25. Insulator 28 is supplied to the surface of back contact solar cell 20 and thereafter cured to form a solid protrusion portion. In other words, if insulator 28 is a thermosetting resin, insulator 28 is cured by heating to promote a cross-linking reaction.

After the protrusion portion of insulator 28 is formed, solder resin paste is supplied on n-type electrode 24 and p-type electrode 25 by a printing method. The solder resin paste includes solder fine powder. The solder fine powder is preferably a solder alloy having a low melting point, typically Sn-Bi, Sn-In based alloy. Ag or Cu may be included to prevent erosion of the electrodes. The particle size of the solder fine powder is preferably 10 to 40 µm. If the particle size exceeds this range, the solder resin paste may not be removed from a print mask during printing. Considering that the solder resin paste is printed so as to be placed on the upper side of n-type electrode 24 and p-type electrode 25, it is desirable that solder fine particle should be closest-packed in the solder resin paste. This allows each electrode to be covered with solder. Supposing that n-type electrode 24 and p-type electrode 25 are formed from sliver, migration can be prevented as well.

After the supply of the solder resin paste, alignment between back contact solar cell 20 and wiring sheet 10 is performed by a mounter. Then, lamination is carried out by a laminator. During lamination, heating and pressing are conducted at the same time. The solder fine powder reaching a melting point by heating starts melting and coagulates together to form a wet continuity path which reaches the wiring on wiring sheet 10. A short circuit would be caused if the resin is cured in a state in which solder wets and reaches both of the electrodes adjacent to each other on the surface of back contact solar cell 20. However, the molten solder is divided apart in the inter-electrode region by the protrusion portion of insulator 28 formed in the present invention and by pressing during lamination. Accordingly, a short circuit can be prevented.

After the continuity path between the electrode of back contact solar cell 20 and the wiring on wiring sheet 10 is formed by solder, the resin component in the solder resin paste is cured by heating in such a manner as to fill in the periphery. The resin component hereafter serves as an underfill.

### (Second Embodiment)

Referring to Fig. 6 to Fig. 17, a method of manufacturing a solar cell module in a second embodiment of the present invention will be described.

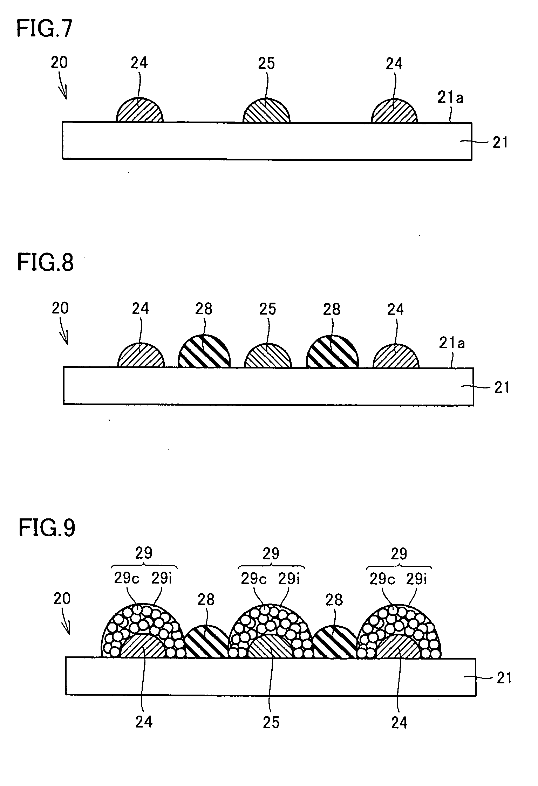

A flowchart of the method of manufacturing a solar cell module is shown in Fig. 6. The wiring sheet used in this manufacturing method may be the one shown in Fig. 2 and Fig. 3 in the first embodiment. The back contact solar cell may be the one shown in Fig. 4 and Fig. 5 in the first embodiment. In Fig. 7 and subsequent figures, the structure of back contact solar cell 20 is simplified for convenience of explanation.

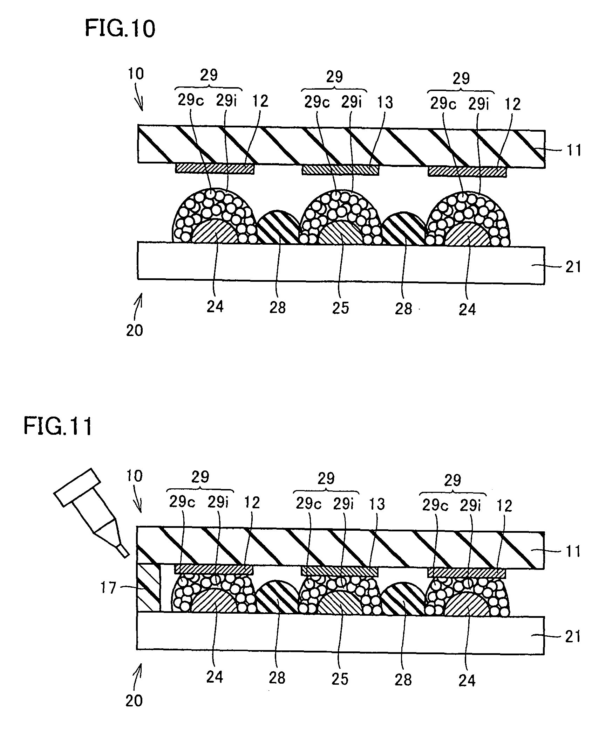

The method of manufacturing a solar cell module includes a step S 1 of preparing back contact solar cell 20 (see Fig. 4, Fig. 5, and Fig. 7) formed such that n-type impurity diffusion region 22 and p-type impurity diffusion region 23 are alternately arranged in a striped pattern in the inside of one surface 21a of semiconductor substrate 21 and such that n-type electrode 24 and p-type electrode 25 electrically connected to n-type impurity diffusion region 22 and p-type impurity diffusion region 23, respectively, are alternately arranged in a striped pattern on the one surface 21 a. The method of manufacturing a solar cell module further includes a second step S2 of supplying insulator 28 in each gap between n-type electrode 24 and p-type electrode 25 adjacent to each other on the one surface 21a of back contact solar cell 20, and a step S3 of curing insulator 28, as shown in Fig. 8. The method of manufacturing a solar cell further includes a fourth step S4 of supplying a mixture 29 of insulating resin 29i, having a composition different from insulator 28, and conductor 29c on n-type electrode 24 and p-type electrode 25, as shown in Fig. 9. The method of manufacturing a solar cell module further includes a fifth step S5 of mounting wiring sheet 10 (see Fig. 2 and Fig. 3), formed such that n-type wiring 12 and p-type wiring 13 are alternately arranged in a striped pattern on the surface of the sheet-like insulating substrate 11, on the one surface 21a of back contact solar cell 20, such that n-type electrode 24 and p-type electrode 25 and n-type wiring 12 and p-type wiring 13 satisfy a one-to-one relationship, as shown in Fig. 10 and Fig. 11. In Fig. 11, preliminary fixing is performed using preliminary fixing resin 17. The method of manufacturing a solar cell module further includes a step S6 of pressing wiring sheet 10 and back contact solar cell 20 while heating.

The method of manufacturing a solar cell module will be described in more detail below.

### (Wiring Sheet)

Wiring sheet 10 as an example of the wiring sheet used in the method of manufacturing a solar cell module will be described.

Fig. 3 schematically shows a plan view of wiring sheet 10 as viewed from the side on which wiring is mounted. Wiring sheet 10 has insulating substrate 11, and n-type wiring 12 and p-type wiring 13 mounted on a surface of insulating substrate 11. N-type wiring 12 and p-type wiring 13 have their respective conductivity. N-type wiring 12 and p-type wiring 13 are each shaped like a comb which includes a shape in which a plurality of linear portions are arranged in a direction 82 orthogonal to a longitudinal direction 81.

In wiring sheet 10, n-type wiring 12 and p-type wiring 13 are arranged such that the portions corresponding to the teeth of the comb-like n-type wiring 12 and the portions corresponding to the teeth of the comb-like p-type wiring 13 mesh with each other alternately one by one. As a result, the portions corresponding to the teeth of the comb-like n-type wiring 12 and the portions corresponding to the teeth of the comb-like p-type wiring 13 are alternately arranged one by one at prescribed intervals. Instead of forming n-type wiring 12 and p-type wiring 13 both in an integral comb-like shape, one of them or both of them may be divided into plural portions rather than formed in an integral shape. In any case, one of n-type wiring 12 and p-type wiring 13 is configured to include a part at least partially positioned in between the other wiring.

A cross section of wiring sheet 10 is schematically shown in Fig. 2. In wiring sheet 10, n-type wiring 12 and p-type wiring 13 are mounted only on one surface of insulating substrate 11. The thickness of insulating substrate 11 is, for example, 25 µm or more and 150 µm or less, though not being limited thereto. Insulating substrate 11 may be a single-layer structure including only one layer or may be a multilayer structure including two or more layers.

### (Back Contact Solar Cell)

Back contact solar cell 20 will be described as an example of the back contact solar cell used in the method of manufacturing a solar cell module.

A cross section of back contact solar cell 20 is schematically shown in Fig. 4. Back contact solar cell 20 is basically formed from semiconductor substrate 21. Semiconductor substrate 21 may be, for example, an n-type or p-type silicon substrate. One surface of semiconductor substrate 21 is a surface serving as a light-receiving surface and having projections and depressions. An antireflective coating 27 is formed on the light-receiving surface of semiconductor substrate 21. A passivation film 26 is formed on the surface that is not the light-receiving surface, that is, the back surface of semiconductor substrate 21.

In the inside of the vicinity of the surface on the back surface side of semiconductor substrate 21, n-type impurity diffusion region 22 formed by diffusing an n-type impurity such as phosphor and p-type impurity diffusion region 23 formed by diffusing a p-type impurity such as boron are alternately formed at prescribed intervals. Contact holes are provided in passivation film 26. N-type electrode 24 and p-type electrode 25 are provided on passivation film 26. N-type electrode 24 and p-type electrode 25 are electrically connected to n-type impurity diffusion region 22 and p-type impurity diffusion region 23, respectively, through the contact holes in passivation film 26.

Here, on the back surface side of semiconductor substrate 21 having n-type or p-type conductivity, a pn junction is formed at an interface between n-type impurity diffusion region 22 or p-type impurity diffusion region 23 and the other inside region of semiconductor substrate 21 (hereinafter referred to as "non-diffusion region"). Whichever conductivity, p-type or n-type, semiconductor substrate 21 has, n-type impurity diffusion region 22 and p-type impurity diffusion region 23 are each in contact with the non-diffusion region inside semiconductor substrate 21. Therefore, n-type electrode 24 and p-type electrode 25 are each considered as an electrode corresponding to each of a plurality of pn junctions formed on the back surface side of semiconductor substrate 21.

The height of each of n-type electrode 24 and p-type electrode 25 may be, for example, 50 µm.

Fig. 5 schematically shows a plan view of back contact solar cell 20 as viewed from the surface that is not the light-receiving surface, that is, the back surface side. N-type electrode 24 and p-type electrode 25 are each formed like a comb. The portions corresponding to the teeth of the comb-like n-type electrode 24 and the portions corresponding to the teeth of the comb-like p-type electrode 25 are arranged so as to mesh with each other alternately one by one. As a result, the portions corresponding to the teeth of the comb-like n-type electrode 24 and the portions corresponding to the teeth of the comb-like p-type electrode 25 are alternately arranged one by one at prescribed intervals.

The shape and arrangement of n-type electrode 24 and p-type electrode 25 on the back surface of back contact solar cell 20 is not limited to the structure shown in Fig. 5 as long as the shape and arrangement can electrically connect to n-type wiring 12 and p-type wiring 13 of wiring sheet 10. The structure of back contact solar cell 20 is schematically shown in Fig. 7.

As shown in Fig. 7, n-type electrode 24 and p-type electrode 25 are alternately arranged on surface 21 a of semiconductor substrate 21 of back contact solar cell 20 prepared in step S1. In step S2, insulator 28 is supplied in the region between these electrodes, as shown in Fig. 8. Insulator 28 may be a resin composition made of epoxy resin having a viscosity of 200Pa·s. Insulator 28 is preferably a thermosetting resin or a photo-curable resin. Insulator 28 is arranged linearly in parallel with the longitudinal direction of n-type electrode 24 and p-type electrode 25. Insulator 28 is arranged by a printing method such that its height is 50 µm. The height of insulator 28 is preferably equal to or greater than the height of n-type electrode 24 and p-type electrode 25. Here, given that the height of n-type electrode 24 and p-type electrode 25 is 50 µm, the height of insulator 28 is 50 µm. However, insulator 28 may be formed to be higher.

Thereafter, in step S3, back contact solar cell 20 is heated in an oven, whereby insulator 28 is cured.

Then, in step S4, as shown in Fig. 9, mixture 29 is arranged by a printing method on n-type electrode 24 and p-type electrode 25 on back contact solar cell 20. Mixture 29 is prepared by kneading a thermosetting resin and Sn-Bi-Ag solder fine powder with a particle size of 20 µm. In other words, mixture 29 is resin paste containing solder particles. The melting point of conductor 29c is preferably lower than the curing temperature of insulating resin 29i.

The amount of mixture 29 to be supplied to one electrode by a printing method is determined by subtracting the volume of n-type electrode 24 or p-type electrode 25 on back contact solar cell 20, the volume of n-type wiring 12 or p-type wiring 13 on wiring sheet 10, and the volume of insulator 28 applied in the previous step, from the volume of an individual space available for connection.

Then, in step S5, as shown in Fig. 10, back contact solar cell 20 is registered with wiring sheet 10. The registration is performed by adjusting the relative position such that n-type wiring 12 on wiring sheet 10 is positioned on n-type electrode 24 on back contact solar cell 20 and that p-type wiring 13 on wiring sheet 10 is positioned on p-type electrode 25 on back contact solar cell 20. In Fig. 10, wiring sheet 10 is positioned above and back contact solar cell 20 is positioned below. However, the absolute vertical relation may not always be like this.

By mounting wiring sheet 10 on back contact solar cell 20, n-type wiring 12 and p-type wiring 13 on wiring sheet 10 come into contact with mixture 29 on back contact solar cell 20.

In the alignment between wiring sheet 10 and back contact solar cell 20, some mark may be used. For example, the relative position of wiring sheet 10 is adjusted by an alignment apparatus (not shown) such that an alignment mark formed at wiring sheet 10 is matched with an alignment mark formed at back contact solar cell 20. After the alignment using the alignment apparatus, fixing is performed using preliminary fixing resin 17 as shown in Fig. 11. Preliminary fixing resin 17 may be a ultra violet-curable resin. By doing so, the relative positional relation between wiring sheet 10 and back contact solar cell 20 is maintained.

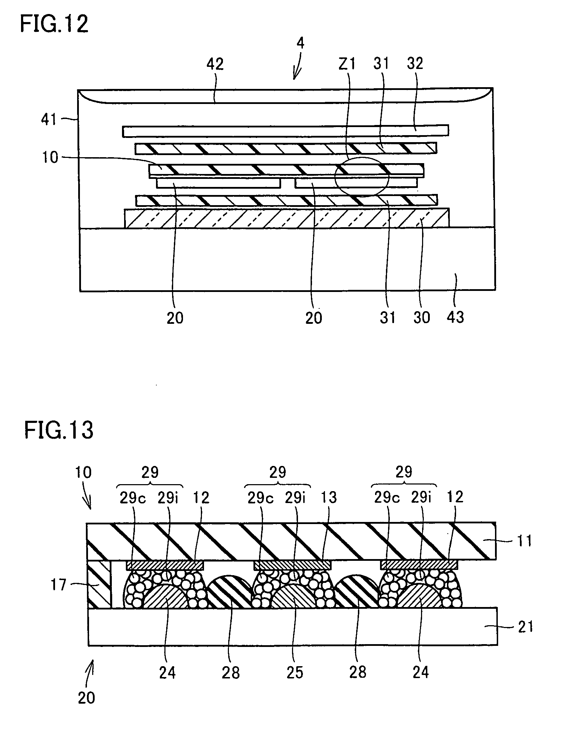

Then, a lamination apparatus 4 shown in Fig. 12 can be used. Here, a lamination apparatus is shown by way of example, although the use of such an apparatus is not necessarily essential. Lamination apparatus 4 includes a chamber 41 and a heater 43 capable of vacuum-compression-bonding and heating processing. Here, "vacuum-compression-bonding" is a process of compression-bonding in an atmosphere under a reduced pressure lower than the atmospheric pressure. In the vicinity of the upper end of the inside of chamber 41, a rubber film 42 is stretched out to partition the inside of chamber 41 into upper and lower spaces.

In chamber 41, a transparent substrate 30 is installed. A sealing material 31 of ethylene vinyl acetate resin (EVA resin) is mounted on transparent substrate 30. Back contact solar cell 20 on which wiring sheet 10 is mounted as described above is mounted on sealing material 31. Transparent substrate 30 may be a glass substrate. An enlarged view of a Z1 portion in Fig. 12 is shown in Fig. 13. Wiring sheet 10 and back contact solar cell 20 are in the preliminarily fixed state by preliminary fixing resin 17. Preliminary fixing resin 17 is actually present at a place other than the Z1 portion but here is depicted in Fig. 13 for convenience of explanation.

Sealing material 31 of ethylene vinyl acetate resin (EVA resin) is mounted again on wiring sheet 10, and a back surface protective sheet 32 of a PET film is mounted on sealing material 31. Here, heater 43 may be kept at about 160°C. Meanwhile, the relative positional relation between wiring sheet 10 and back contact solar cell 20 is held by preliminary fixing resin 17.

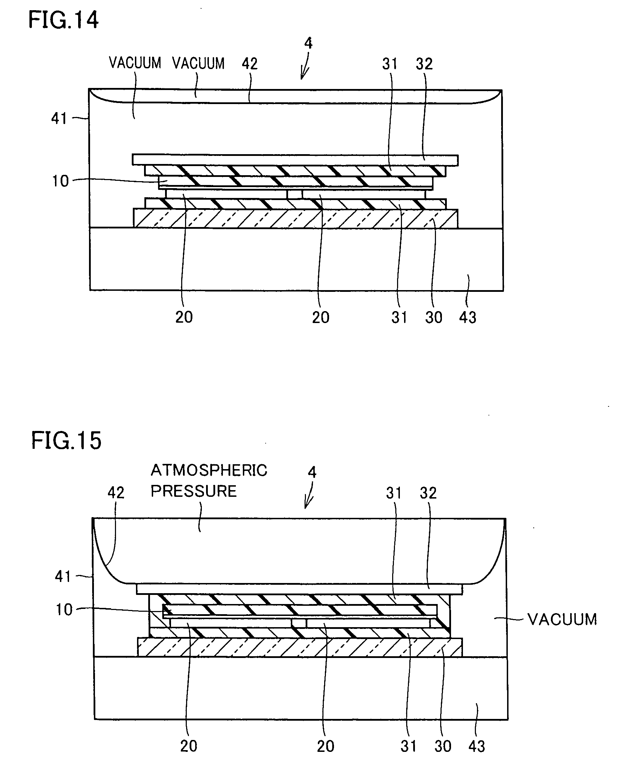

Then, as shown in Fig. 14, the space under rubber film 42 is evacuated while the space above rubber film 42 is kept in a vacuum, with the temperature between back contact solar cell 20 and wiring sheet 10 being kept at about 60 to about 100°C by heater 43. With this state, voids (bubbles) present in a region between wiring sheet 10 and back contact solar cell 20 can be removed.

Although the temperature of heater 43 is kept at about 160°C, the temperature between back contact solar cell 20 and wiring sheet 10 rises to only about 80°C for about one minute after being mounted on heater 43, in the state in which transparent substrate 30, sealing material 31, back contact solar cell 20, wiring sheet 10, sealing material 31, and back surface protective sheet 32 are only laid on one another on heater 43 with the spaces above and below rubber film 42 being kept in a vacuum.

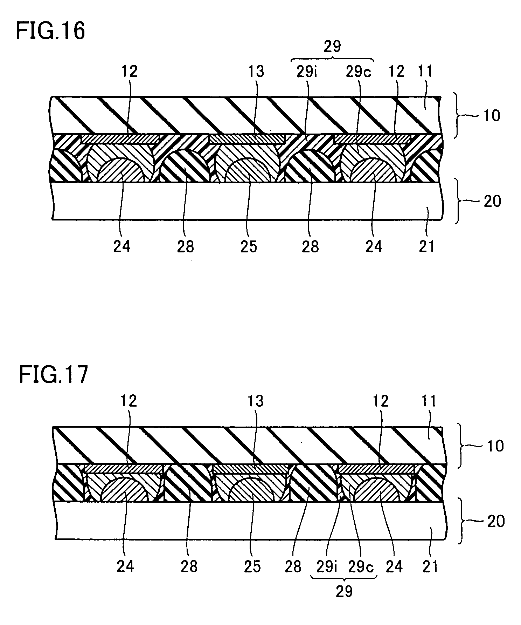

Thereafter, as shown in Fig. 15, the space above rubber film 42 of lamination apparatus 4 is opened to the atmospheric pressure. By doing so, rubber film 42 is pushed downward. Accordingly, sealing material 31 on the transparent substrate 30 side is compression-bonded to back contact solar cell 20, and sealing material 31 on the wiring sheet 10 side is compression-bonded to wiring sheet 10, whereby heat from heater 43 is easily transmitted. Therefore, the temperature of mixture 29 formed by kneading solder fine powder and thermosetting resin reaches about 160°C, and the solder fine powder contained in mixture 29 starts melting. Simultaneously with the melting, the solder fine powder starts coagulating together to form a sizable amount of liquid solder, which moves from the electrode on back contact solar cell 20 to the wiring on wiring sheet 10. This state is also referred to as "solder wets toward the wiring on wiring sheet 10." This state is shown in Fig. 16. The coagulating portion of the solder fine powder contained in mixture 29 becomes a bump-like conductor 29c which extends from each of n-type electrode 24 and p-type electrode 25 to n-type wiring 12 or p-type wiring 13 at opposing locations. The resin component contained in mixture 29 becomes insulating resin 29i which fills the peripheral space.

Meanwhile, sealing material 31 liquefies to enclose the periphery of wiring sheet 10 and back contact solar cell 20 as shown in Fig. 15.

At the moment when alignment is finished, mixture 29 printed on n-type electrode 24 and p-type electrode 25 is crushed to expand, and the crushed mixture 29 expands in the inter-electrode region. Therefore, it can be assumed that there exists an area in which solder wets to extend over the electrodes adjacent to each other during lamination. However, rubber film 42 is pressed downward by opening the space above rubber film 42 to the atmosphere. Therefore, the distance between wiring sheet 10 and back contact solar cell 20 is compressed in the decreasing direction. Insulator 28 of a resin composition is arranged in the inter-electrode region, where the height of insulator 28 is equal to or greater than the height of n-type electrode 24 and p-type electrode 25. Thus, when the distance between wiring sheet 10 and back contact solar cell 20 is reduced, as shown in Fig. 17, insulator 28 is the first that comes into abutment with the bottom surface of wiring sheet 10. Since insulator 28 is arranged linearly in parallel with the electrode in the inter-electrode region, mixture 29 expanding over both electrodes adjacent to each other is pushed apart and divided by insulator 28. Therefore, even if there exists an area in which the wet solder extends over both electrodes adjacent to each other, the area is divided apart. With respect to the wettability of solder, n-type wiring 12 or p-type wiring 13 on wiring sheet 10 is superior to insulator 28. Therefore, the solder wets and expands on the wiring rather than on insulator 28. In this manner, a short circuit between electrodes is prevented.

Even after the solder forms a continuity path between the wiring on wiring sheet 10 and back contact solar cell 20, the cross-linking reaction proceeds in the thermosetting resin as insulating resin 29i contained in mixture 29. As shown in Fig. 17, insulating resin 29i covers the periphery of conductor 29c. With only supply of mixture 29 onto the wiring, the thermosetting resin as insulating resin 29i contained in mixture 29 might not be able to solely fill the space in the inter-electrode region completely. However, in the present embodiment, because of insulator 28 formed in the inter-electrode region in advance, the bonding space can be entirely filled with mixture 29 and insulator 28. The solar cell module shown in Fig. 1 is thus obtained.

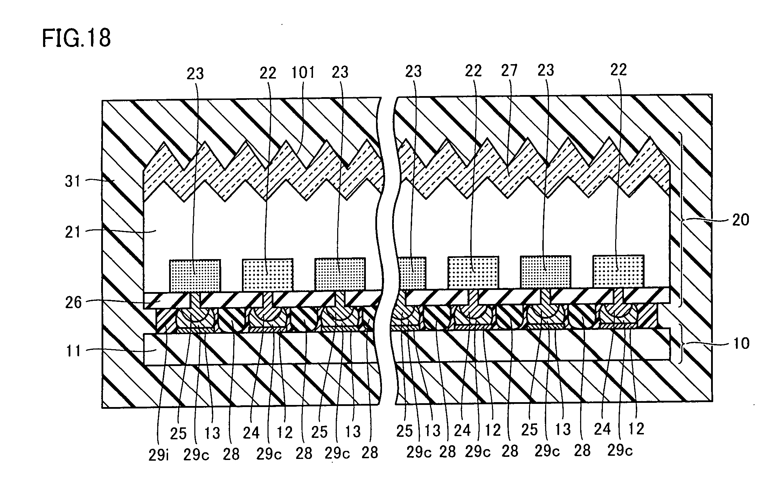

In the processing by lamination apparatus 4, simultaneously with the reaction between wiring sheet 10 and back contact solar cell 20, the setting reaction of sealing material 31 shown in Fig. 15 also proceeds. Sealing material 31 sets in a state in which it is sandwiched between transparent substrate 30 and back surface protective sheet 32. The setting of sealing material 31 results in a structure in which the foregoing solar cell module is sealed in the inside of sealing material 31, that is, the structure shown in Fig. 18.

With the method of manufacturing a solar cell module in the present embodiment, the electrodes of back contact solar cell 20 and the wiring on wiring sheet 10 can be compression-bonded to each other while a short circuit between electrodes or between wiring adjacent to each other is prevented. Therefore, a highly reliable solar cell module can be produced.

The method of manufacturing a solar cell module in the present embodiment preferably includes the step of preliminarily fixing back contact solar cell 20 and wiring sheet 10, after step S5 of mounting, as described above. More specifically, for example, as shown in Fig. 11, fixing is achieved by preliminary fixing resin 17. The inclusion of the preliminary fixing step can prevent a shift in relative positional relation between back contact solar cell 20 and wiring sheet 10 in the lamination process.

The embodiment disclosed here should be understood as being illustrative rather than being limitative in all respects. The scope of the present invention is shown not in the foregoing description but in the claims, and it is intended that all modifications that come within the meaning and range of equivalence to the claims are embraced here.

### INDUSTRIAL APPLICABILITY

The present invention is applicable to a solar cell module and a method of manufacturing the same.

### REFERENCE SIGNS LIST

4 lamination apparatus, 10 wiring sheet, 11 insulating substrate, 12 n-type wiring, 13 p-type wiring, 17 preliminary fixing resin, 20 back contact solar cell, 21 semiconductor substrate, 21a surface, 22 n-type impurity diffusion region, 23 p-type impurity diffusion region, 24 n-type electrode, 25 p-type electrode, 26 passivation film, 27 antireflective coating, 28 insulator, 29 mixture, 29c conductor, 29i insulating resin, 30 transparent substrate, 31 sealing material, 32 back surface protective sheet, 41 chamber, 42 rubber film, 43 heater, 81, 82 direction, 101 solar cell module.

## Claims

1. A solar cell module (101) comprising:
a wiring sheet (10) formed such that n-type wiring (12) and p-type wiring (13) are alternately arranged in a striped pattern on a surface of a sheet-like insulating substrate (11); and
a back contact solar cell (20) formed such that an n-type impurity diffusion region (22) and a p-type impurity diffusion region (23) are alternately arranged in a striped pattern in the inside of one surface of a semiconductor substrate (21) and such that an n-type electrode (24) and a p-type electrode (25) electrically connected to said n-type impurity diffusion region and said p-type impurity diffusion region, respectively, are alternately arranged in a striped pattern on said one surface, wherein
said n-type electrode and said p-type electrode and said n-type wiring and said p-type wiring are connected through conductors (29c) so as to satisfy a one-to-one relationship,
a periphery of said conductor is covered with an insulating resin (29i), and
an insulator (28) having a composition different from said insulating resin is mounted between said n-type electrode and said p-type electrode adjacent to each other on said back contact solar cell.

2. The solar cell module according to claim 1, wherein said insulator is a thermosetting resin or a photo-curable resin.

3. A method of manufacturing a solar cell module comprising the steps of:
preparing a back contact solar cell (20) formed such that an n-type impurity diffusion region (22) and a p-type impurity diffusion region (23) are alternately arranged in a striped pattern in the inside of one surface of a semiconductor substrate (21) and such that an n-type electrode (24) and a p-type electrode (25) electrically connected to said n-type impurity diffusion region and said p-type impurity diffusion region, respectively, are alternately arranged in a striped pattern on said one surface;
supplying an insulator (28) in each gap between said n-type electrode and said p-type electrode adjacent to each other on said one surface of said back contact solar cell;
curing said insulator;
supplying a mixture (29) of an insulating resin (29i), having a composition different from said insulator, and a conductor (29c) on said n-type electrode and said p-type electrode;
mounting a wiring sheet (10), formed such that n-type wiring (12) and p-type wiring (13) are alternately arranged in a striped pattern on a surface of a sheet-like insulating substrate (11), on said one surface of said back contact solar cell, such that said n-type electrode and said p-type electrode and said n-type wiring and said p-type wiring satisfy a one-to-one relationship; and
pressing said wiring sheet and said back contact solar cell while heating.

4. The method of manufacturing a solar cell module according to claim 3, wherein said insulator is a thermosetting resin or a photo-curable resin.

5. The method of manufacturing a solar cell module according to claim 3, wherein a melting point of said conductor is lower than a curing temperature of said insulating resin.

6. The method of manufacturing a solar cell module according to claim 3, further comprising the step of preliminarily fixing said back contact solar cell and said wiring sheet, after said step of mounting.
